Europäisches Patentamt

European Patent Office

Office européen des brevets

(11) Numéro de publication : **0 462 002 B1**

(12) **FASCICULE DE BREVET EUROPEEN**

(19)

(45) Date de publication du fascicule du brevet :
**16.02.94 Bulletin 94/07**

(21) Numéro de dépôt : **91401560.7**

(22) Date de dépôt : **12.06.91**

(51) Int. Cl.⁵ : **G01R 33/26**

(54) **Magnétomètre à résonance et à pompage optique utilisant une polarisation séquentielle.**

(30) Priorité : **14.06.90 FR 9007410**

(43) Date de publication de la demande :
**18.12.91 Bulletin 91/51**

(45) Mention de la délivrance du brevet :
**16.02.94 Bulletin 94/07**

(84) Etats contractants désignés :
**BE DE GB IT NL SE**

(56) Documents cités :
**EP-A- 0 246 146**
**EP-A- 0 288 927**
**GB-A- 964 028**
**US-A- 3 211 994**
**US-A- 3 641 426**
**REVUE DE PHYSIQUE APPLIQUEE. vol. 5,
Février 1970, PARIS FR pages 121 - 130; J.L.
MEILLEROUX: 'Progrès récents sur le magnétomètre à vapeur de césium type "asservi" '**

(56) Documents cités :
**Mesures, Régulation, Automatisme, Vol. 45,
No. 12, 1980, pages 69-72, R. Chassagnon et
al. "Polarisation des gaz. Système d'étude
automatique piloté par calculateur".**

(73) Titulaire : **COMMISSARIAT A L'ENERGIE
ATOMIQUE
31-33, rue de la Fédération
F-75015 Paris (FR)**

(72) Inventeur : **Chaillout, Jean-Jacques
Le Montagnier Haut
F-38960 St Etienne de Crossey (FR)**
Inventeur : **Kernevez, Nelly
14, boulevard Maréchal Leclerc
F-38000 Grenoble (FR)**
Inventeur : **Leger, Jean-Michel
51C, Rue des Ayguinards
F-38240 Meylan (FR)**

(74) Mandataire : **Mongrédien, André et al
c/o BREVATOME 25, rue de Ponthieu
F-75008 Paris (FR)**

## Description

La présente invention a pour objet un magnétomètre.

Elle trouve une application dans la mesure précise des champs magnétiques faibles (typiquement dans la plage de 20 à 70$\mu$T correspondant aux valeurs du champ magnétique terrestre).

Le magnétomètre de l'invention entre dans la catégorie des magnétomètres dits à résonance, dont on pourra trouver une description générale dans l'article de F. HARTMAN intitulé "Resonance Magnetometers", publié dans la revue "IEEE Transactions on Magnetics", vol. MAG-8, n° 1, March 1972, pp. 66-75.

Un magnétomètre à résonance est un appareil qui, plongé dans un champ magnétique Bo, délivre un signal électrique de fréquence F dont la valeur est liée à Bo par la relation dite de LARMOR :
$$F = \gamma Bo$$
où $\gamma$ est un rapport gyromagnétique (d'un électron ou d'un nucléon selon la substance utilisée). Pour l'électron par exemple, ce rapport est égal à 28Hz/nT.

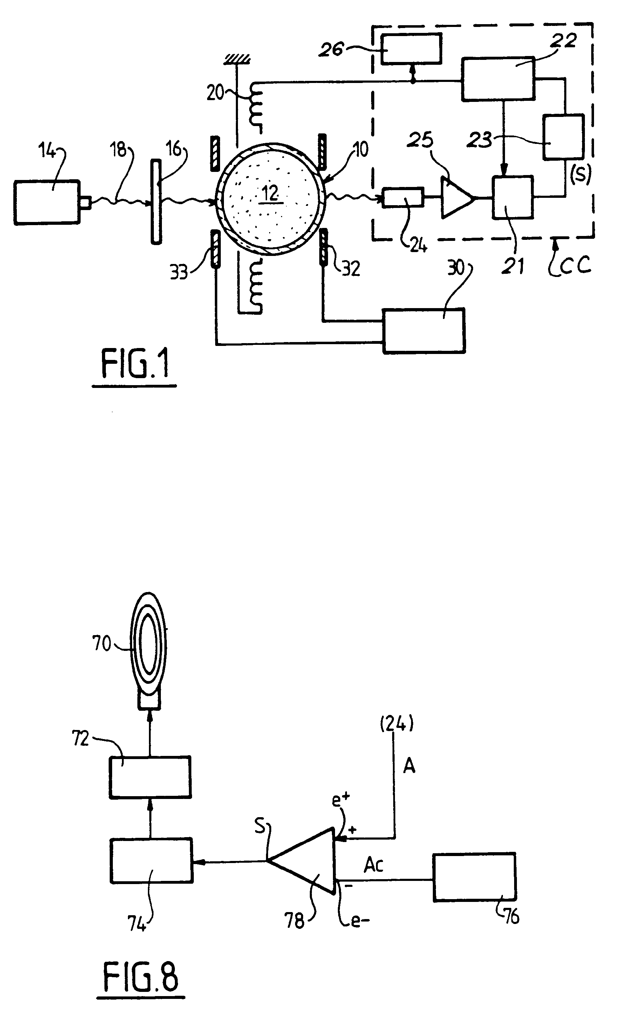

Dans cette classe d'appareils, le magnétomètre à pompage optique occupe une place privilégiée. La constitution générale d'un magnétomètre à pompage optique et à résonance magnétique est représentée schématiquement sur la figure 1.

Une cellule 10, au moins partiellement transparente, est remplie d'un gaz 12, en général de l'hélium à une pression de 1 à quelques torrs. Une source lumineuse 14 délivre un faisceau lumineux 18 dont la longueur d'onde se situe autour de 1,1$\mu$m dans le cas de l'hélium. Ce faisceau est convenablement polarisé par un moyen 16 puis injecté dans la cellule 10.

Par ailleurs, une décharge radio-fréquence (dite "faible" ou "douce") est produite dans le gaz par un générateur 30 relié à deux électrodes 32, 33 disposées autour de la cellule 10. Cette décharge produit des atomes dans un état métastable ($2^3S_1$ dans le cas de l'hélium). Le faisceau lumineux incident "pompe" ces atomes à partir de l'état métastable pour les amener dans un autre état excité ($2^3P$).

En présence d'un champ magnétique Bo, les niveaux d'énergie se séparent en sous-niveaux, dits de ZEEMAN. Une résonance radio-fréquence entre de tels sous-niveaux peut être établie par un champ radio-fréquence (résonance magnétique) ou par une modulation de la lumière (double résonance optique ; COHEN, TANNOUDJI, Ann. Phys., 7, 1962, p. 423). Dans le cas de l'hélium, isotope 4, la résonance s'établit entre deux sous-niveaux électroniques ZEEMAN de l'état métastable.

Cette résonance est mise en évidence par divers moyens électroniques connus de l'homme du métier, dont une variante est représentée sur la figure 1. Il s'agit d'un enroulement 20 disposé de part et d'autre de la cellule 10 (dans une disposition dite de HELMOLTZ), d'un générateur radio-fréquence 22, d'un photodétecteur 24 recevant le rayonnement lumineux ayant traversé la cellule, d'un amplificateur 25, d'une détection synchrone 21 et d'un intégrateur 23. L'ensemble des moyens 21 à 26 sera désigné par la référence CC dans la suite. Le générateur 22 alimente l'enroulement 20 en courant à la fréquence F, ce qui crée un champ magnétique oscillant dont une composante entretient la résonance et module en retour le faisceau lumineux ayant traversé la cellule. Cette modulation constitue le signal. Elle est mise en évidence par la détection synchrone en sortie du photodétecteur via l'amplificateur. La référence est donnée par le générateur. La sortie de 'la détection synchrone correspondant à la composante du signal en phase avec la référence sert de signal d'erreur. L'intégrateur en élimine l'erreur statique Le signal d'erreur réajuste la fréquence F du synthétiseur à la fréquence de LARMOR. Il faut pour cela que le synthétiseur soit pilotable en tension ; il peut également être remplacé par un oscillateur commandé en tension (V.C.O.).

Un signal électrique de résonance S s'établit ainsi dans cette boucle, à la fréquence de LARMOR. Un fréquencemètre 26 en donne la valeur F. Le champ à mesurer Bo s'en déduit par la relation Bo=F/$\gamma$.

Les magnétomètres à hélium de ce type ont d'abord utilisé des lampes à hélium. L'obtention récente de cristaux d'aluminate de lanthane-néodyme (ou LNA) ayant permis de réaliser des lasers accordables autour de la longueur d'onde de 1,083$\mu$m correspondant précisément à la raie de pompage optique de l'hélium, ce type de laser s'est substitué tout naturellement à ces lampes avec une amélioration sensible des performances, ce qui a donné un regain d'intérêt à ces appareils.

Un tel magnétomètre, équipé d'un laser à LNA, est décrit dans le document FR-A-2 598 518.

Bien que satisfaisants à certains égards, ces magnétomètres présentent cependant des inconvénients. En effet, par principe, ils sont fortement anisotropes, et ceci à la fois en amplitude et en fréquence. Des extinctions de signal se produisent pour certaines orientations du champ magnétique à mesurer. Ces orientations défavorables correspondantes soit à certaines directions de propagation du faisceau lumineux (dans le cas d'une polarisation circulaire) soit à certaines directions de polarisation (dans le cas d'une polarisation rectiligne). Le pompage optique ne produit plus la polarisation requise des sous-niveaux ZEEMAN des atomes, ou la détection de la résonance se révèle inefficace.

Diverses solutions ont été proposées pour remédier à cet inconvénient. La Société américaine Texas Instruments, par exemple, préconise l'utilisation de plusieurs cellules orientées de telle sorte que l'une au moins fournisse un signal exploitable. La Société canadienne Canadian Aviation Electronics préconise plutôt d'orienter convenablement le magnétomètre par rapport au champ à mesurer.

Les zones d'extinction du signal étant plus étendues pour un faisceau polarisé rectilignement que pour un faisceau polarisé circulairement, on préfère en général travailler en polarisation circulaire. Cependant, avec ce type de polarisation, un phénomène de déplacement de fréquence se produit, du fait du pompage optique, qui provoque des erreurs de mesure.

La Société Texas Instruments remédie à cet autre inconvénient toujours en doublant le nombre des cellules, et en faisant fonctionner l'une d'entre elles en polarisation circulaire droite et l'autre en polarisation circulaire gauche. Les décalages de fréquence observés dans les deux cellules étant de signes opposés, une compensation est possible en effectuant la moyenne des fréquences mesurées par les deux magnétomètres. Une solution de même nature avait déjà été décrite dans l'article de J.L. Meilleroux, intitulé « Progrès récents sur le magnétomètre à vapeur de Césium , type "asservi" » publié dans la Revue de Physique Appliquée, 1970, tome 5, pages 121-130.

Toutes ces solutions, qui reviennent à multiplier le nombre d'appareils, restent peu satisfaisantes : encombrement excessif, nécessité d'équilibrer les diverses voies de mesure, commande de l'orientation des cellules, consommation électrique élevée, etc.... Par ailleurs, toute l'installation doit être réalisée dans un environnement amagnétique, ce qui pose de redoutables problèmes technologiques.

La présente invention a justement pour but de remédier à ces inconvénients. A cette fin, elle propose un magnétomètre à résonance et à pompage optique dont l'isotropie est excellente tout en restant simple de construction et peu encombrant (il ne comprend qu'une seule cellule) et facile à mettre en oeuvre.

Ce but est atteint par l'invention grâce à l'utilisation de moyens aptes à modifier séquentiellement la polarisation du faisceau lumineux injecté dans la cellule. La pluralité de polarisations employées entraîne l'obtention d'une pluralité de composantes pour le signal de résonance, ces composantes étant plus ou moins affaiblies et/ou affectées d'erreur (selon l'orientation du champ à mesurer par rapport à la polarisation employée). Il est toujours possible d'extraire de ces composantes un signal de mesure débarrassé de ces défauts. Dés lors, quelle que soit l'orientation du champ magnétique à mesurer, il est possible d'extraire du magnétomètre un signal significatif.

Selon une première variante de l'invention, on travaille en polarisation circulaire. Les moyens pour modifier séquentiellement la polarisation du faisceau lumineux font alors passer celle-ci alternativement d'une polarisation circulaire droite à une polarisation circulaire gauche. Le signal électrique de résonance présente alors alternativement deux fréquences différentes, correspondantes aux deux erreurs de signes contraires commises en polarisation circulaire, comme exposé plus haut. Les moyens de traitement d'un tel signal sont aptes à effectuer la moyenne de ces deux fréquences, moyenne qui est débarrassée de toute erreur de mesure.

Selon une seconde variante de l'invention, on opère en polarisation rectiligne. Les moyens pour modifier séquentiellement la polarisation donnent alors successivement à celle-ci une direction selon l'une quelconque de $n$ directions différentes, $n$ étant un entier au moins égal à 2, par exemple égal à 3.

Les moyens pour détecter le signal de résonance délivrent alors une pluralité de $n$ signaux ayant une même fréquence mais des amplitudes différentes. Ceux des signaux qui correspondent à des directions de polarisation peu favorables eu égard à la direction du champ à mesurer, présentent des amplitudes faibles, voire nulles ; mais, du fait de la variété de directions de polarisation utilisée, il existe nécessairement des directions de polarisation plus favorables, qui conduisent, elles, à des signaux plus intenses.

Dans cette variante à polarisation rectiligne, deux modes de réalisation sont prévus :

- le premier consiste à prendre la moyenne des amplitudes de la pluralité des $n$ signaux obtenus ; cette moyenne est nécessairement supérieure à la plus petite des amplitudes obtenues : le signal de mesure est donc toujours supérieur au signal qui serait délivré par un magnétomètre placé dans les conditions les plus défavorables ;

- le second consiste à comparer l'amplitude du signal de résonance obtenu avec l'une des directions de polarisation avec une valeur de consigne ; si cette amplitude est inférieure à la valeur de consigne, on continue à modifier séquentiellement la direction de polarisation ; dès que l'une des amplitudes excède la valeur de consigne, on arrête la modification de direction et l'on maintient la direction de polarisation correspondant à cette amplitude.

Toutes ces dispositions s'appliquent aux magnétomètres à résonance et à pompage optique quel que soit le milieu pompé. Naturellement, dans l'état actuel de la technique, l'hélium joue un rôle privilégié. Mais d'autres gaz ou fluides connus ou à venir ne sont pas exclus pour autant de l'invention, comme par exemple les vapeurs de métaux alcalins (césium, rubidium, ...). La résonance peut être magnétique (excitation par un champ RF) ou optique (modulation de la lumière, multirésonance optique).

De même, si le laser à LNA joue un rôle privilégié dans le pompage des cellules à hélium, l'invention ne se limite pas à cette source et tout magnétomètre utilisant une source lumineuse quelconque fait partie de l'invention, dès lors qu'il travaille séquentiellement en polarisation.

De toute façon, les caractéristiques et avantages de l'invention apparaîtront mieux à la lumière de la description qui va suivre. Cette description porte sur des exemples de réalisation, donnés à titre explicatif et non limitatif. Elle se réfère par ailleurs à des dessins annexés sur lesquels :

- la figure 1, déjà décrite, montre un magnétomètre de l'art antérieur ;
- la figure 2 montre un mode de réalisation d'un magnétomètre selon l'invention, dans une variante à polarisation circulaire ;
- la figure 3 est un schéma explicatif des différentes polarisations circulaires utilisées ;
- la figure 4 montre un autre mode de réalisation, toujours dans la variante à polarisation circulaire ;
- la figure 5 est un schéma explicatif des différentes polarisations circulaires utilisées ;
- la figure 6 montre un magnétomètre dans une variante à polarisation rectiligne à changement de directions ;
- la figure 7 est un schéma montrant la pluralité de directions de polarisation et le signal filtré correspondant ;
- la figure 8 porte sur un mode de réalisation à comparaison.

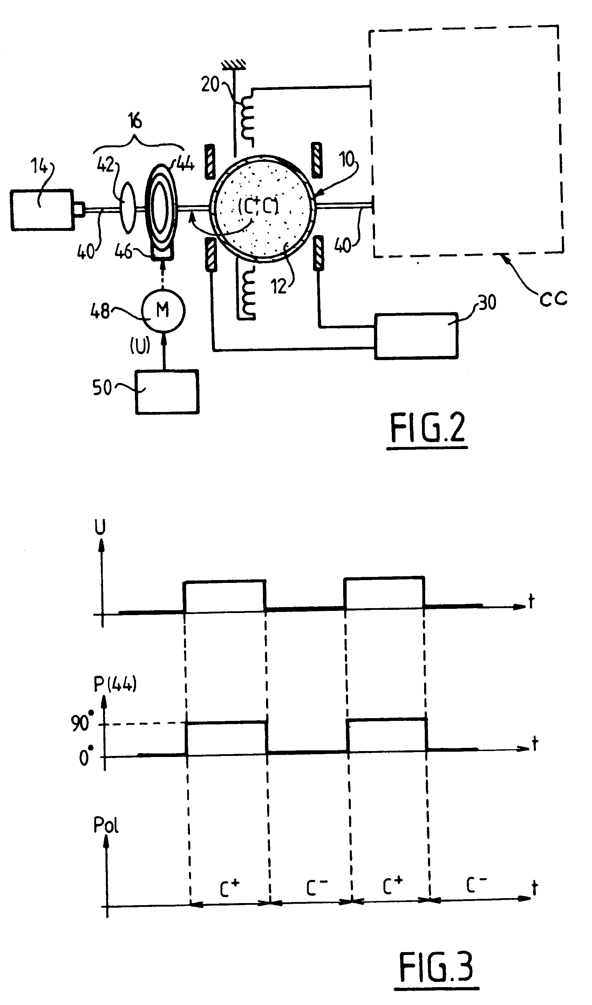

Le magnétomètre représenté sur la figure 2 comprend des moyens déjà illustrés sur la figure 1 et qui portent, pour cette raison, les mêmes références numériques. Il s'agit de la cellule 10 remplie d'hélium, du laser 14, du moyen de polarisation 16, de l'enroulement 20, du circuit CC (comprenant le circuit d'excitation de la résonance 22, le photodétecteur 24, le fréquencemètre 20, l'amplificateur 25, la détection synchrone 21 et l'intégrateur 23) et du générateur de décharge 30. Selon une première variante de l'invention, le moyen de polarisation 16 comprend un polariseur rectiligne 42 et un polariseur circulaire 44. Ce dernier est monté sur un support orientable 46 apte à faire basculer de 90° le polariseur 44. Un moteur 48 agit sur le support 46. Il est commandé par un générateur basse fréquence 50.

Tel que représenté sur la figure 2, le magnétomètre comprend des fibres optiques 40 pour guider la lumière entre le laser 14 et le photorécepteur 24. Cette disposition est avantageuse mais nullement obligatoire.

Le schéma de la figure 3 montre, sur la première ligne, la forme de la tension U délivrée par le générateur 50. Cette tension présente la forme de créneaux. La position du polariseur 44 est illustrée sur la deuxième ligne. Elle est tantôt parallèle à une direction de référence notée 0°, tantôt à 90° de cette référence.

Sur la troisième ligne, on voit la succession des polarisations qui en résulte pour le faisceau lumineux injecté dans la cellule : alternativement circulaire droite ($C^+$) et circulaire gauche ($C^-$).

Naturellement, si la source lumineuse 14 émet un faisceau déjà polarisé rectilignement, comme c'est parfois le cas avec les lasers, le polariseur rectiligne 42 devient inutile.

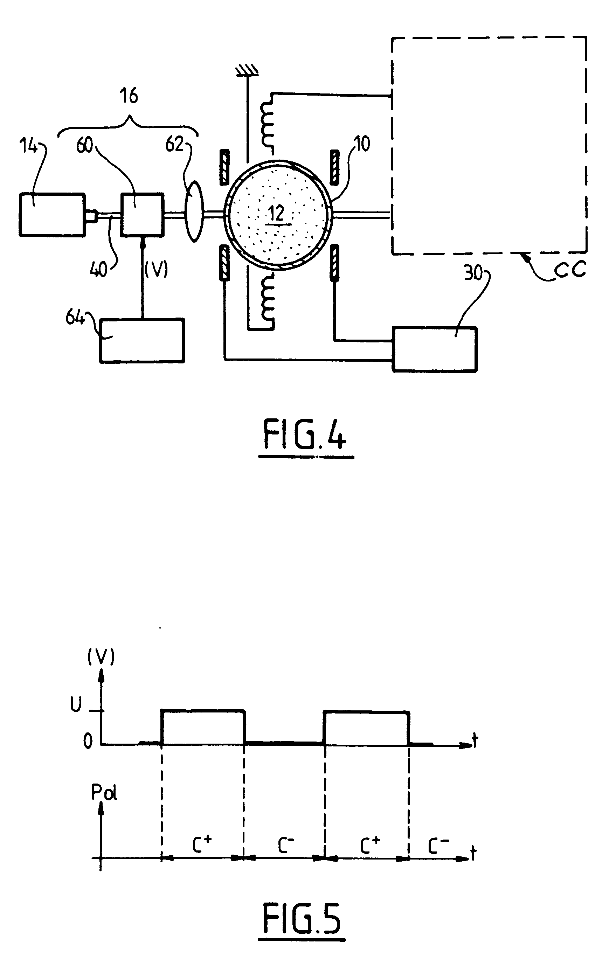

L'homme du métier peut imaginer aisément d'autres modes de réalisation des moyens permettant de passer d'une polarisation circulaire droite à une polarisation circulaire gauche. La figure 4 montre ainsi un autre mode de réalisation utilisant une valve à cristaux liquides 60 associée à un polariseur circulaire 62 fixe. La valve 60 est commandée par un générateur basse fréquence 64.

Lorsque la tension appliquée est nulle, les cristaux sont orientés suivant leur axe ordinaire. Lorsque la tension est nominale (V), les cristaux sont orientés selon leur axe extraordinaire (les axes sont perpendiculaires à celui de la propagation du faisceau). La polarisation rectiligne en sortie de la valve bascule de 90°. A la sortie du polariseur circulaire, le faisceau est polarisé circulairement alternativement à droite et à gauche. L'avantage de ce mode de réalisation est de ne nécessiter aucune pièce en mouvement. La polarisation du faisceau avant la valve doit permettre de délivrer la puissance lumineuse suivant les deux directions de polarisation. Cela peut être réalisé en sortie d'une fibre optique qui dépolarise le faisceau et répartit la puissance dans l'espace de polarisation.

La figure 5 illustre ce mécanisme.

Dans cette variante de l'invention à inversion du sens de polarisation circulaire, le signe de l'erreur de fréquence commise s'inverse à chaque changement de sens. Si l'inversion est réalisée à une fréquence suffisamment élevée (très supérieure à 1Hz), elle ne sera pas observée car elle sera filtrée par les filtres passe-bas (1er ou 2ème ordre) ou par les boucles d'asservissement de phase utilisés dans la détection du signal : l'erreur moyennée est donc nulle à la sortie du photodétecteur 24.

D'autres dispositifs électro-optiques peuvent être utilisés en lieu et place de la valve à cristaux liquides (cellules à cristaux électro-optiques solides, etc...).

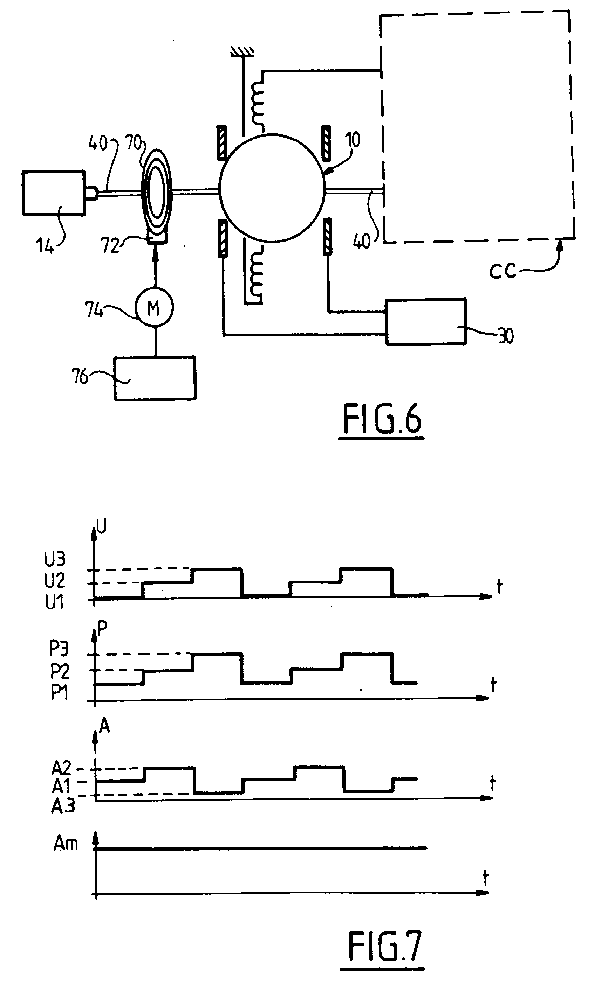

Selon une seconde variante de l'invention, qui est illustrée par les figures 6 à 8, on travaille en polarisation rectiligne.

Dans ce mode de réalisation illustré sur la figure 6, tout d'abord un polariseur rectiligne 70 est monté sur un support orientable 72 et peut prendre n positions (par exemple 3). Ces positions définissent n directions entre 0° et 90° disposées à 90°/n-1 les unes des autres (par exemple 3 positions à 0°-45°-90°). Le support est commandé en position par un moteur 74, lui-même commandé par un générateur basse fréquence 76.

Le schéma de la figure 7 montre les trois tensions U1, U2, U3 appliquées séquentiellement sur le moteur (ligne du haut), et les trois positions correspondantes P1, P2, P3 prises par la polarisation (deuxième ligne).

Selon la direction prise par la polarisation, l'angle entre cette direction et le champ magnétique à mesurer est plus ou moins favorable et l'amplitude du signal de résonance plus ou moins grande. Les trois amplitudes A1, A2, A3 présentées par le signal de résonance sont représentées sur la troisième ligne.

Si le changement de direction de polarisation s'effectue à une fréquence suffisamment rapide (très supérieure à 1Hz), un filtre 27, placé en sortie des moyens de détection du signal de résonance, filtrera le signal détecté et délivrera un signal moyen (ligne du bas de la figure 7). L'amplitude de ce signal est relativement indépendante de la direction du champ magnétique : le magnétomètre est quasi isotrope.

Le choix du nombre n de directions de polarisation dépend de l'isotropie recherchée. Avec n=3, pour une détection magnétique transverse, on obtient une isotropie de plus de 50% (l'isotropie étant définie comme le rapport entre l'amplitude minimale obtenue dans le cas le plus défavorable et l'amplitude maximale obtenue dans le cas le plus favorable).

Selon un mode de réalisation illustré sur la figure 8, le magnétomètre comprend un moyen 76 apte à délivrer une valeur de consigne Ac, un comparateur 78 qui reçoit, sur une première entrée e$^+$, l'amplitude A du signal détecté, et, sur une seconde entrée e$^-$, la valeur de consigne Ac. Ce comparateur 78 possède une sortie s reliée au moteur 74.

L'état logique de cette sortie (par exemple "1"), obtenu lorsque l'amplitude mesurée A est inférieure à la valeur de consigne Ac, a pour effet de commander l'application sur le moteur d'une tension apte à modifier la direction de polarisation. L'apparition de l'autre état logique sur cette sortie ("O"), lorsque l'amplitude mesurée A excède la valeur de consigne Ac, a pour effet d'arrêter la commande du moteur afin que la polarisation rectiligne correspondante soit maintenue.

**Revendications**

1. Magnétomètre à résonance et à pompage optique comprenant une cellule (10) remplie d'un gaz (12) dont les atomes présentent un rapport gyromagnétique γ, une source lumineuse (14) émettant un faisceau lumineux, un polariseur (16) traversé par ce faisceau, le faisceau ayant traversé le polariseur étant injecté dans la cellule (10) et étant apte à y pomper optiquement le gaz, des moyens de détection (20 à 25) d'un signal électrique de résonance (S) à une fréquence de LARMOR F=γBo où Bo est un champ magnétique ambiant dans lequel plonge la cellule (10) et qui est le champ à mesurer, un moyen (26) pour mesurer cette fréquence, l'amplitude du champ magnétique ambiant se déduisant de la fréquence F par la relation Bo=F/γ, ce magnétomètre étant caractérisé par le fait qu'il comprend en outre :
   - des moyens (42, 44, 46, 48, 50), (60, 62, 64), (70, 72, 74) pour modifier séquentiellement la polarisation du faisceau lumineux injecté dans la cellule (10), le signal de résonance détecté (S) présentant alors, une pluralité de composantes,
   - des moyens de traitement de cette pluralité de composantes pour en extraire un signal global de mesure.

2. Magnétomètre selon la revendication 1, le faisceau optique injecté dans la cellule (10) présentant une polarisation circulaire, caractérisé par le fait que :
   - les moyens (42, 44, 46, 48, 50), (60, 62, 64) pour modifier séquentiellement la polarisation du faisceau lumineux font passer la polarisation alternativement d'une polarisation circulaire droite (C$^+$) à une polarisation circulaire gauche (C$^-$), les moyens de détection du signal de résonance délivrant alors deux signaux de fréquences différentes,
   - les moyens de traitement du signal séquentiel étant aptes à mesurer la moyenne (Fm) des deux fréquences obtenues.

3. Magnétomètre selon la revendication 2, caractérisé par le fait que les moyens pour modifier séquentiellement la polarisation du faisceau en une polarisation circulaire droite et gauche comprennent un polariseur circulaire (44) recevant un faisceau lumineux à polarisation rectiligne, ce polariseur circulaire (44) étant disposé sur un support orientable (46), un moteur (48) pour faire basculer de 90° le polariseur, un générateur basse fréquence (50) pour commander le moteur (48).

4. Magnétomètre selon la revendication 2, caractérisé par le fait que le moyen pour modifier séquentiellement la polarisation du faisceau en une polarisation circulaire droite et gauche comprend un dispositif électro-optique (60) délivrant un faisceau à polarisation rectiligne dirigée selon l'une ou l'autre de deux directions rectangulaires, un générateur basse fréquence (64) pour commander le dispositif électro-optique (60), un polariseur circulaire (62) recevant le faisceau délivré par le dispositif électro-optique (60).

5. Magnétomètre selon la revendication 4, caractérisé par le fait que le dispositif électro-optique (60) est une cellule à cristaux liquides.

6. Magnétomètre selon la revendication 1, le faisceau optique injecté dans la cellule présentant une polarisation rectiligne, caractérisé par le fait que les moyens pour modifier séquentiellement la polarisation donnent successivement à cette polarisation rectiligne une direction selon n directions différentes, n étant au moins égal à 2, les moyens de détection du signal de résonance délivrant alors une pluralité de n signaux différant les uns des autres par leur amplitude.

7. Magnétomètre selon la revendication 6, caractérisé par le fait qu'il comprend, après les moyens de détection et avant le moyen de mesure de fréquence (26), un moyen apte à faire la moyenne des n signaux détectés.

8. Magnétomètre selon la revendication 6, caractérisé par le fait qu'il comprend, en outre, un moyen (76) apte à délivrer une valeur de consigne (Ac), un comparateur (78) recevant, sur une première entrée ($e^+$), l'amplitude (A) du signal détecté, et, sur une seconde entrée ($e^-$), la valeur de consigne (Ac), ce comparateur (78) ayant une sortie (s) reliée au moteur (74), l'état logique de cette sortie (s), obtenu lorsque l'amplitude mesurée (A) est inférieure à la valeur de consigne (Ac), commandant le moteur (74) pour la modification séquentielle de la direction de polarisation et l'état logique de cette sortie (s), obtenu lorsque l'amplitude mesurée (A) excède la valeur de consigne (Ac), arrêtant le moteur (74).

9. Magnétomètre selon l'une quelconque des revendications 6 à 8, caractérisé par le fait que le moyen pour modifier séquentiellement la polarisation rectiligne comprend un polariseur rectiligne (70) monté sur un support orientable (72), un moteur (74) apte à faire basculer successivement de 90°/n-1 jusqu'au retour à 0° le polariseur et un générateur basse fréquence (76) pour commander le moteur (74).

10. Magnétomètre selon l'une quelconque des revendications 1 à 9, caractérisé par le fait que le gaz (12) de la cellule (10) est de l'hélium.

11. Magnétomètre selon la revendication 10, caractérisé par le fait qu'il comprend en outre des moyens (30, 32) pour créer une décharge haute fréquence dans la cellule d'hélium (10).

12. Magnétomètre selon l'une quelconque des revendications 1 à 11, caractérisé par le fait que la source lumineuse (14) est un laser.

13. Magnétomètre selon l'une quelconque des revendications 1 à 12, caractérisé par le fait que le faisceau lumineux est guidé entre la source (14) et la cellule (10), d'une part, et entre la cellule (10) et un photodétecteur (24), d'autre part, par une fibre optique (40).

**Patentansprüche**

1. Optisch gepumptes Resonanzmagnetometer, das eine Zelle (10), die mit einem Gas (12) gefüllt ist, dessen Atome ein gyromagnetisches Verhältnis γ aufweisen, eine Lichtquelle (14), die einen Lichtstrahl aussendet, einen Polarisator (16), der von diesem Strahl durchlaufen wird, wobei der Strahl, wenn er den Polarisator durchlaufen hat, in die Zelle (10) eingeführt wird und dazu fähig ist, das Gas optisch zu pumpen, Geräte zur Detektion (20 bis 25) eines elektrischen Resonanzsignals (S) bei einer LARMOR-Frequenz F=γBo, wobei Bo ein umgebendes Magnetfeld ist, in welches die Zelle (10) eintaucht und welches das zu messende Feld ist, ein Gerät (26) umfaßt, um diese Frequenz zu messen, wobei die Amplitude des umgebenden Magnetfeldes sich von der Frequenz F durch die Beziehung Bo=F/γ ableitet, dieses Magnetometer wird dadurch gekennzeichnet, daß es außerdem:
   - Geräte (42, 44, 46, 48, 50), (60, 62, 64), (70, 72, 74) umfaßt, um aufeinanderfolgend die Polarisation des in die Zelle (10) eingeführten Lichtstrahls zu modifizieren, wobei das detektierte Resonanzsignal (S) folglich eine Vielzahl von Komponenten aufweist,
   - Geräte zur Verarbeitung dieser Vielzahl an Komponenten umfaßt, um daraus ein globales Meßsignal herauszuziehen.

2. Magnetometer gemäß Anspruch 1, wobei der in die Zelle (10) eingeführte optische Strahl eine drehende Polaristation aufweist, dadurch gekennzeichnet, daß:
   - die Geräte (42, 44, 46, 48, 50), (60, 62, 64), um aufeinanderfolgend die Polarisation des Lichtstrahls zu modifizieren, abwechselnd die Polarisation von einer rechtsdrehenden Polarisation ($C^+$) in eine linksdrehende Polarisation ($C^-$) übergehen lassen, wobei die Geräte zur Detektion des Resonanzsignals folglich zwei verschiedene Frequenzsignale liefern,
   - Geräte zur Verarbeitung des folgenden Signals, die dazu fähig sind, den Durchschnitt (fm) der beiden erhaltenen Frequenzen zu messen.

3. Magnetometer gemäß Anspruch 2, dadurch gekennzeichnet, daß die Geräte zur aufeinanderfolgenden Modifikation der Polarisation des Strahls in eine rechts- und linksdrehende Polarisation einen drehenden Polarisator (44), der einen Lichtstrahl mit geradliniger Polarisation empfängt, wobei dieser drehende Polarisator (44) auf einer ausrichtbaren Stütze (46) angebracht ist, einen Motor (48), um den Polarisator schnell um 90° drehen zu lassen, und einen Tieffrequenzgenerator (50) umfassen, um den Motor (48) zu steuern.

4. Magnetometer gemäß Anspruch 2, dadurch gekennzeichnet, daß das Gerät zur aufeinanderfolgenden Modifikation der Polarisation des Strahls in eine rechts- und linksdrehende Polarisation eine elektro-optische Vorrichtung (60), die einen Strahl mit geradliniger Polarisation liefert, der gegen die eine oder die andere der beiden rechtwinkligen Richtungen gerichtet ist, einen Tieffrequenzgenerator (64) zur Steuerung der elektrooptischen Vorrichtung (60), und einen drehenden Polarisator (62) umfaßt, der den von der elektrooptischen Vorrichtung (60) gelieferten Strahl empfängt.

5. Magnetometer gemäß Anspruch 4, dadurch gekennzeichnet, daß die elektro-optische Vorrichtung (60) eine Flüssigkristall-Zelle ist.

6. Magnetometer gemäß Anspruch 1, wobei der in die Zelle eingeführte optische Strahl eine geradlinige Polarisation aufweist, dadurch gekennzeichnet, daß die Geräte, um aufeinanderfolgend die Polarisation zu modifizieren, nacheinander dieser geradlinigen Polarisation eine Richtung gemäß n verschiedenen Richtungen geben, wobei n mindestens gleich 2 ist, und die Geräte zur Detektion des Resonanzsignals folglich eine Vielzahl n, in ihrer Amplitude verschiedenen, Signalen liefern.

7. Magnetometer gemäß Anspruch 6, dadurch gekennzeichnet, daß es nach den Geräten zur Detektion und vor den Geräten zur Messung der Frequenz (26) ein Gerät umfaßt, das dazu fähig ist, den Mittelwert der n detektierten Signale zu bilden.

8. Magnetometer gemäß Anspruch 6, dadurch gekennzeichnet, daß es außerdem ein Gerät (76), das fähig ist, einen Einstellwert (Ac) zu liefern, und einen Komparator (78) umfaßt, der an einem ersten Eingang (e+) die Amplitude (A) des detektierten Signals und an einem zweiten Eingang (e-) den Einstellwert (Ac) empfängt, wobei dieser Komparator (78) einen mit dem Motor (74) verbundenen Ausgang (S) hat und der logische Zustand dieses Ausgangs (S), der erhalten wird, wenn die gemessene Amplitude (A) kleiner ist als der Einstellwert (Ac), den Motor (74) für die nachfolgende Modifikation der Polarisationsrichtung steuert und der logische Zustand dieses Ausgangs (S), der erhalten wird, wenn die gemessene Amplitude (A) den Einstellwert (Ac) überschreitet, den Motor (74) anhält.

9. Magnetometer gemäß einem der Ansprüche 6 bis 8, dadurch gekennzeichnet, daß das Gerät, um aufeinanderfolgend die geradlinige Polarisation zu modifizieren, einen geradlinigen Polarisator (70), der auf einer ausrichtbaren Stütze (72) befestigt ist, einen Motor (74), der dazu fähig ist, den Polarisator schnell von 90°/n-1 bis zurück auf 0° zu drehen, und einen Tieffrequenzgenerator (76) zur Steuerung des Motors (74) umfaßt.

10. Magnetometer gemäß einem der Ansprüche 1 bis 9, dadurch gekennzeichnet, daß das Gas (12) der Zelle (10) Helium ist.

11. Magnetometer gemäß Anspruch 10, dadurch gekennzeichnet, daß es außerdem Geräte (30, 32) umfaßt, um eine Hochfrequenzentladung in der Heliumzelle (10) zu erzeugen.

12. Magnetometer gemäß einem der Ansprüche 1 bis 11, dadurch gekennzeichnet, daß die Lichtquelle (14) ein Laser ist.

13. Magnetometer gemäß einem der Ansprüche 1 bis 12, dadurch gekennzeichnet, daß der Lichtstrahl einerseits zwischen der Quelle (14) und der Zelle (10) und andererseits zwischen der Zelle (10) und einem Photodetektor (24) von einer Lichtfaser (40) geleitet wird.

## Claims

1. Optical pumping, resonance magnetometer comprising a cell (10) filled with a gas (12), whose atoms have a gyromagnetic ratio $\gamma$, a light source (14) emitting a light beam, a polarizer (16) traversed by said beam, the beam having traversed the polarizer being injected into the cell (10) and able to optically pump there the gas, detection means (20 to 25) of an electrical resonance signal (S) at a LARMOR frequency $F = \gamma B_o$, in which $B_o$ is an ambient magnetic field in which the cell (10) is immersed and which is the field to be measured, a means (26) for measuring the said frequency, the amplitude of the ambient magnetic field being deduced from the frequency F by the relation $B_o = F/\gamma$, said magnetometer being characterized in that it also comprises means (42, 44, 46, 48, 50), (60, 62, 64), (70, 72, 74) for sequentially modifying the polarization of the light beam injected into the cell (10), the detected resonance signal (S) then having a plurality of components and means for processing said plurality of components in order to extract therefrom an overall measurement signal.

2. Magnetometer according to claim 1, the optical beam injected into the cell (10) having a circular polarization, characterized in that the means (42, 44, 46, 48, 50), (60, 62, 64) for sequentially modifying the polarization of the light beam pass the polarization alternately from a clockwise circular polarization ($C^+$) to an anticlockwise circular polarization ($C^-$), the resonance signal detection means then supplying two signals of different frequencies and the sequential signal processing means are able to measure the mean value (Fm) of the two frequencies obtained.

3. Magnetometer according to claim 2, characterized in that the means for sequentially modifying the polarization of the beam into a clockwise or anticlockwise circular polarization comprise a circular polarizer (44) receiving a light beam with a linear polarization, said circular polarizer (44) being located on an orientable support (46), a motor (48) for tilting the polarizer by 90° and a low frequency generator (50) for controlling the motor (48).

4. Magnetometer according to claim 2, characterized in that the means for sequentially modifying the polarization of the beam into a clockwise and anticlockwise circular polarization comprises an electrooptical device supplying a beam with a linear polarization directed in one or other of two rectangular directions, a low frequency generator (64) for controlling the electrooptical device (60) and a circular polarizer (62) receiving the beam supplied by the electrooptical device (60).

5. Magnetometer according to claim 4, characterized in that the electrooptical device (60) is a liquid crystal cell.

6. Magnetometer according to claim 1, the optical beam injected into the cell having a linear polarization, characterized in that the means for sequentially modifying the polarization successively give said linear polarization a direction in n different directions, n being at least equal to 2, the resonance signal detection means then supplying a plurality of n signals which differ from one another by their amplitude.

7. Magnetometer according to claim 6, characterized in that it comprises, following the detection means and before the frequency measuring means (26), a means able to form the mean of the n detected signals.

8. Magnetometer according to claim 6, characterized in that it also comprises a means (76) able to supply a nominal value (Ac), a comparator (78) receiving on a first input ($e^+$) the amplitude (A) of the detected signal and on a second input ($e^-$) the nominal value (Ac), said comparator (78) having an output (s) connected to the motor (74), the logic state of said output (s), obtained when the measured amplitude (A) is below the nominal value (Ac), controlling the motor (74) for the sequential modification of the polarization direction and the logic state of said output (s), obtained when the measured amplitude (A) exceeds the nominal value (Ac) stops the motor (74).

9. Magnetometer according to any one of the claims 6 to 8, characterized in that the means for sequentially modifying the linear polarization comprises a linear polarizer (70) mounted on an orientable support (72), a motor (74) able to successively tilt the polarizer by 90°/n-1 up to the return to 0° and a low frequency generator (76) for controlling the motor (74).

10. Magnetometer according to any one of the claims 1 to 9, characterized in that the gas (12) in the cell (10) is helium.

11. Magnetometer according to claim 10, characterized in that it also comprises means (30, 32) for creating a high frequency discharge in the helium cell (10).

12. Magnetometer according to any one of the claims 1 to 11, characterized in that the light source (14) is a laser.

13. Magnetometer according to any one of the claims 1 to 12, characterized in that the light beam is guided between the source (14) and the cell (10) on the one hand and between the cell (10) and a photo-detector (24) on the other by an optical fibre (40).

FIG.1

FIG.8

EP 0 462 002 B1

FIG.2

FIG.3

10

FIG.4

FIG.5

## FIG.6

## FIG.7